Europäisches Patentamt

European Patent Office

Office européen des brevets

(19)

(11) Numéro de publication: **0 230 078 B1**

(12) **FASCICULE DE BREVET EUROPEEN**

(45) Date de publication de fascicule du brevet:
10.04.91

(51) Int. Cl.⁵: **H01L 33/00**, H01L 31/0203,
H01L 23/29

(21) Numéro de dépôt: 86202298.5

(22) Date de dépôt: **16.12.86**

(54) Procédé d'encapsulation d'un composant électronique au moyen d'une résine synthétique.

(30) Priorité: **20.12.85 FR 8518922**

(43) Date de publication de la demande:
**29.07.87 Bulletin 87/31**

(45) Mention de la délivrance du brevet:
**10.04.91 Bulletin 91/15**

(84) Etats contractants désignés:
**DE FR GB IT**

(56) Documents cités:
DE-A- 3 019 239
US-A- 3 980 483
US-A- 4 034 466

**PATENTS ABSTRACTS OF JAPAN, vol. 6, no. 147 (E-123)[1025], 6 août 1982; & JP-A-57 71 154**

**CHEMICAL ABSTRACTS, vol. 102, no. 24, 17 juin 1985, page 41, résumé no. 204893c, Columbus, Ohio, US; & JP-A-59 213 779**

(73) Titulaire: **PHILIPS COMPOSANTS
117, quai du Président Roosevelt
F-92130 Issy les Moulineaux(FR)FR**

Titulaire: **N.V. Philips' Gloeilampenfabrieken
Groenewoudseweg 1
NL-5621 BA Eindhoven(NL)DE GB IT**

(72) Inventeur: **Voinis, Sylvie Société Civile S.P.I.D.
209, rue de l'Université
F-75007 Paris(FR)**
Inventeur: **Nijboer, Sjoerd Société Civile
S.P.I.D.
209, rue de l'Université
F-75007 Paris(FR)**

(74) Mandataire: **Pinchon, Pierre et al
Société Civile S.P.I.D. 156, Boulevard Haussmann
F-75008 Paris(FR)**

## Description

La présente invention concerne un procédé d'encapsulation d'un composant électronique consistant à ce que, après avoir fixé et relié électriquement un dispositif actif à des conducteurs métalliques, on effectue, au moyen d'une résine synthétique, au moins un enrobage au dehors duquel les conducteurs émergent partiellement.

La grande majorité des composants électroniques, et en particulier les composants semiconducteurs, requièrent une protection de l'élément actif lequel ne pourrait fonctionner convenablement en restant exposé à un environnement non contrôlé. Ainsi les composants comportent-ils généralement une enveloppe de protection qui permet également de fournir une disposition standardisée des conducteurs sous la forme de broches de sortie à dimensions et écartement choisis parmi des valeurs normalisées.

Dans certains cas, on prévoit d'encapsuler les composants électroniques dans des boitiers de type métallique et/ou céramique, la fermeture de ces boitiers pouvant faire appel à la soudure électrique, la brasure ou la fusion de verre tendre. Cependant, les techniques de ce type sont nécessairement coûteuses de sorte qu'elles sont plutôt réservées à des produits devant résister à des contraintes d'environnement particulièrement sévères.

Dans les autres cas, on a plus généralement recours à des procédés d'encapsulation faisant appel à un enrobage par une résine synthétique, procédés consistant le plus souvent à mouler autour du composant actif ladite résine, qui constitue après solidification, le boitier du composant et dont les conducteurs, partiellement emprisonnés par la résine, émergent cependant à l'extérieur en vue de leur raccordement électrique ultérieur.

En dehors des composants opto-électroniques, les dispositifs semi-conducteurs doivent être protégés de la lumière ambiante pour éviter que n'apparaissent des photocourants indésirables lors du fonctionnement. C'est pourquoi ces dispositifs requièrent une encapsulation par une résine opaque à la lumière.

Au contraire, les dispositifs opto-électroniques comme les diodes électroluminescentes, les photodiodes, les phototransistors et les photocoupleurs nécessitent une encapsulation qui soit au moins partiellement transparente au rayonnement pour lequel le dispositif est appelé à fonctionner, soit vis-à-vis de l'extérieur du boitier, soit exclusivement dans la partie interne du dispositif où s'effectue un couplage optique (cas des photocoupleurs).

L'invention vise un procédé d'encapsulation conforme au préambule particulièrement lorsqu'il est appliqué à un dispositif opto-électronique, que l'encapsulation soit effectuée en une seule étape ou encore qu'elle le soit en plusieurs étapes selon le procédé connu du brevet des Etats-Unis d'Amérique n° 4034 466.

A la lecture de ce document, il apparait clairement qu'une exigence spécifique de l'enrobage des diodes électroluminescentes et autres composants opto-électroniques s'ajoute aux exigences générales, à savoir celle concernant l'intégrité des qualités optiques de la surface de l'enrobage, intégrité qui doit être maintenue en toutes circonstances y compris lors de la soudure des composants et de leur rinçage dans certains solvants utilisés à cette occasion.

Une exigence du même ordre concerne le vieillissement des résines, par exemple sous l'effet de l'exposition à la lumière, résines qui ne doivent dans ce cas, ne présenter aucun jaunissement aboutissant à une perte de transmission optique.

La présente invention propose un procédé d'encapsulation permettant de résoudre, au moins dans une large mesure, les difficultés citées à propos des dispositifs opto-électroniques.

Mais plus généralement, l'invention vise également l'encapsulation de tout composant électronique, de manière simple et économique.

En effet, selon l'invention, un procédé d'encapsulation d'un conposant électronique se caractérise en ce qu'en tant que résine synthétique de base on utilise une résine de la famille des éthoxy bisphénol A diméthacrylates dans laquelle on a ajouté un composé photoinitiateur produisant des radicaux par photo-scission ou par abstraction intermoléculaire d'hydrogène, à une concentration comprise entre 0,2 et 3 % en poids et en ce qu'on irradie ensuite ladite résine avec des rayons ultra-violets pour obtenir la polymérisation de l'enrobage.

Patents abstracts of Japan vol.6 no.147(E-123)-[1025], 6 août 1982 et JP-A-57 71 154 concernent l'encapsulation d'un composant opto-electronique dans une résine de la famille des bisphénol A.

Parmi un nombre important de résines photopolymérisables susceptibles d'être utilisées dans un procédé d'encapsulation, celles de la famille des ethoxy bisphénol A diméthacrylates se sont révélées les plus avantageuses notamment du fait que d'une part elles sont assez fluides pour être utilisées sans diluant réactif (monomère) ce qui diminue l'effet de retrait lors de la polymérisation, et que d'autre part elles possèdent des qualités optiques et une stabilité chimique remarquables.

Selon le procédé basé sur la photopolymérisation, une élévation de température importante du produit n'est pas nécessaire pour obtenir la polymérisation de la résine ; au contraire, toute élévation notable de température peut être évitée. On évite ainsi les contraintes d'origine thermique au sein du produit fini. De plus, la stabilité des mélanges résine + photoinitiateur avant l'emploi, permet une grande facilité d'utilisation, à l'abri de variations progressives de viscosité comme celles que l'on observe avec des mélanges thermoactivables d'utilisation connue.

Il suffit simplement d'éviter une exposition du mélange à une lumière ambiante contenant une proportion notable de rayons ultra-violets.

En dehors d'additifs secondaires comme des agents d'adhésion par exemple, incorporés éventuellement à dose faible à la résine indiquée, un composé photo initiateur du type mentionné est ajouté à la résine de base à la concentration choisie entre 0,2 et 3 %.

Ceci permet d'obtenir en volume une polymérisation convenable de la résine alors que des concentractions nettement plus élevées (10 à 25 %) sont recommandées en vue d'applications connues des résines photopolymérisables visant des films relativement minces comme des vernis protecteurs ou décoratifs ou encore des encres d'impression.

Enfin la résine de base choisie présente une excellente neutralité chimique et reste stable notamment vis-à-vis de l'humidité ambiante, ce qui offre un bonne garantie contre des dégradations ultérieures des dispositifs encapsulés.

Selon un mode particulier de l'invention dans lequel le processus d'encapsulation comporte une opération de pré-enrobage appliquée directement au dispositif actif et une opération d'enrobage final créant la partie externe de l'encapsulation au sein de Iquelle le volume de pré-enrobage se trouve inclus, le procédé d'encapsulation est caractérisé en ce qu'on utilise pour l'opération de pré-enrobage une résine de base de même nature que celle employée pour l'enrobage final, que l'on irradie par rayons ultra-violets avant de procéder à l'opération d'enrobage final.

Bien que s'écartant de la pratique admise selon laquelle il serait préférable de pratiquer le pré-enrobage avec une résine nettement moins rigide que celle utilisée pour l'enrobage final, ce mode de mise en oeuvre a donné de très bons résultats qui sont attribués à la bonne adhérence des enrobages successifs, l'un à l'autre et à l'absence de contraintes de dilatations qui peuvent se produire dans le cas de la technique connue.

De plus, l'absence de différence d'indice de réfraction entre les deux enrobages supprime la difficulté causée par le dioptre correspondant.

Lorsqu'on utilise un moule en vue d'obtenir une partie externe de l'encapsulation qui soit de forme reproductible et contrôlée au moins en certaines portions spécifiques de son contour, le procédé selon l'invention se caractérise en outre en ce qu'on utilise un moule à paroi pratiquement transparente à la lumière ultra-violette, en ce qu'après avoir fixé en positions respectives et convenables le dispositif muni de ses conducteurs et le moule garni d'une quantité convenable de résine, on irradie aux ultra-violets la résine à travers le moule selon une direction privilégiée choisie pour initier la polymérisation sur la portion de contour externe de l'encapsulation dont la forme doit être la plus fidèlement respectée, conditions qui sont maintenues de sorte qu'un front de polymérisation progressive se déplace au sein de la résine, par translation dans le sens de ladite direction privilégiée.

En procédant ainsi on permet que la partie de résine encore à l'état liquide vienne compenser à chaque instant le déficit de matière provoqué par le retrait consécutif à la polymérisation. On évite le risque de décollement de matière de la paroi du moule et on minimise les contraintes de traction au sein de l'encapsulation plastique. La portion de contour externe de l'encapsulation dont la forme doit être le plus fidèlement respectée polymérise en premier. C'est selon cette portion que le retrait dû à la polymérisation aura le moins d'influence.

C'est ainsi que dans le cas de l'encapsulation de diodes électroluminescentes, en choisissant une direction d'irradiation aux ultra-violets qui frappe le dôme optique de la diode, dans l'axe optique du cristal, on a observé par expérience que ce dôme était après moulage, parfaitement conforme au contour du moule et les performances optiques des diodes, très reproductibles.

Si on le désire, on peut encore avantageusement selon l'invention, appliquer un film relativement mince de résine photopolymérisable de même nature que celle utilisée pour l'opération finale d'enrobage, et avant cette opération, sur le dispositif et les parties des conducteurs qui seront ausi ultérieurement recouvertes par l'enrobage final, puis on irradie ledit film aux rayons ultra-violets jusqu'à polymérisation complète de celui-ci avant de procéder à l'enrobage final. Cette application d'un film de résine peut être faite par exemple, par trempage.

Cette opération complémentaire améliore l'adhésion de l'encapsulation autour des conducteurs métalliques et élimine pratiquement le risque d'infiltration d'humidité ou d'autres espèces corrosives le long de l'interface conducteur-résine. Cet interface est en effet reconnu comme l'un des points faibles de l'encapsulation par résine synthétique.

On a observé par ailleurs, que l'adhésion du film sur la résine de l'enrobage final était excellente au point de ne pouvoir déceler aucune discontinuité dans le composant final ainsi encapsulé.

L'invention vise également l'application du procédé énoncé ci-dessus à l'enrobage des dispositifs semi-conducteurs opto-électroniques et particulièrement à des diodes électroluminescentes.

La description qui va suivre en regard des dessins annexés, donnés à titre d'exemples non limitatifs, fera bien comprendre comment l'invention peut être réalisée.

La figure 1 représente en coupe un composant électronique semiconducteur muni d'une encapsulation selon le procédé conforme à l'invention.

La figure 2 illustre une opération de pré-enrobage d'une diode électroluminescente munie d'une cavité réfléchissante selon un procédé conforme à l'invention.

Les figures 3A et 3B illustrent une étape préparatoire avant enrobage final qui peut être utilisée dans le procédé de l'invention.

La figure 4 montre l'étape d'enrobage final avec utilisation d'un moule, dans le cas d'une diode électroluminescente.

Les figures 5A et 5B illustrent respectivement en plan et en coupe un autre mode de mise en oeuvre de l'invention.

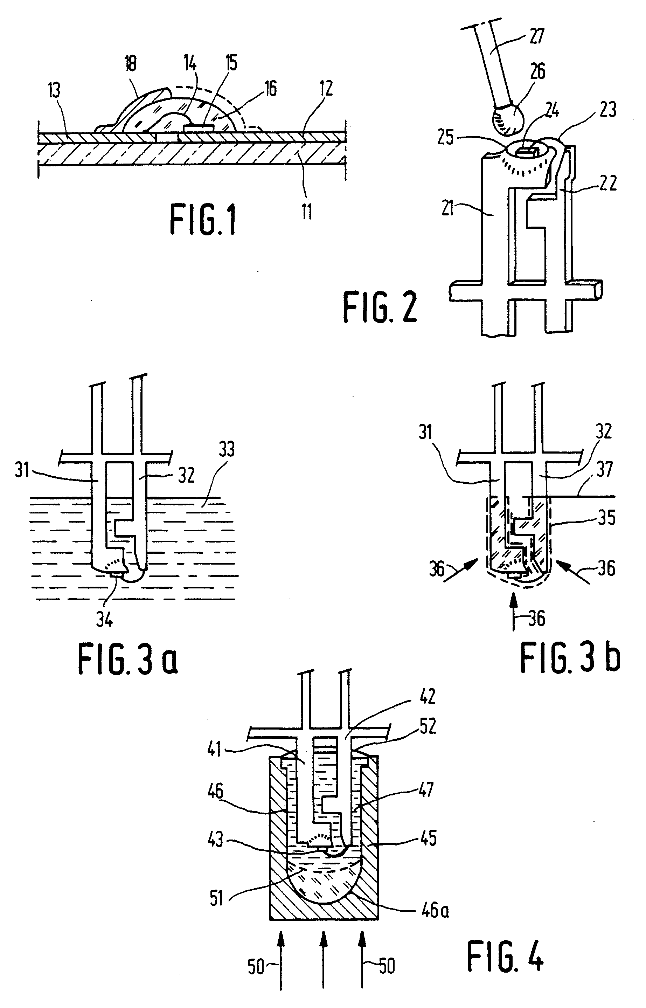

A la figure 1, une portion de substrat isolant 11 est représentée en coupe, portant des pistes conductrices métalliques 12 et 13. L'ensemble du substrat 11 et des pistes conductrices 12 et 13 peut être un circuit imprimé par exemple, ou un substrat en céramique pour circuit électronique dit hybride.

Un composant électronique 15 sous le forme d'un cristal semiconducteur est fixé et relié électriquement à la piste conductrice 12. Une région active du composant 15 est également reliée à la piste conductrice 13 par un fil 14. De manière à protéger le composant 15, une goutte de résine 16 du type ethoxy bisphénol A diméthacrylate dans laquelle on a ajouté un composé photoinitiateur, est déposée sur le composant 15 qui se trouve englobé ansi que le fil 14 dans le ménisque formé par la goutte de résine 16.

Le composé photoinitiateur est du type produisant des radicaux par photo-scission ou par abstration intermoléculaire par élimination d'hydrogène. Il est introduit dans la résine de base à une concentration comprise entre 0,2 et 3 % en poids et de préférence voisine de 1 %.

Une résine de la famille indiquée qui est particulièrement bien adaptée à l'encapsulation de composants électroniques est, par exemple, celle commercialisée par la Société AKZO CHEMIE sous la référence "Diacryl 121".

Cette résine est suffisamment fluide pour pouvoir être utilisée sans addition d'un monomère acrylique, ce qui offre l'avantage d'aboutir à un produit polymérisé peu cassant et avec un retrait minimal.

Un composé photo initiateur du type produisant des radicaux par photoscission convenant particulièrement bien comme addition à la dose de 1 %, à ladite résine de base, est le 2 -hydroxy -2- méthyl -1- phényl propane -1- one, produit qui est commercialisé par la société MERCK sous la référence "Darocur 1 173".

D'autres composés photoinitiateurs peuvent aussi être utilisés comme additifs à la résine de base indiquée, par exemple, un composé du type à activation par abstraction intermoléculaire d'hydrogène comme le benzophénone couplé à un aminoacrylate tel que le produit référencé P 104 commercialisé par la Société Union Chimique Belge.

La goutte de résine 16 est ensuite exposée à des rayons ultra-violets d'intensité modérée pour obtenir une polymérisation complète en un temps de l'ordre de 30 s à 1 minute. Une polymérisation plus rapide a l'inconvénient de produire un échauffement de la matière qui risque d'induire des contraintes indésirables sur le composant électronique encapsulé.

Il est souvent nécessaire d'éviter la pénétration de la lumière ambiante sur le composant notamment lorsqu'il a'agit d'un composant semi-conducteur. On peut si nécessaire, recouvrir la goutte de résine 16 d'un film opaque approprié qui a été représenté partiellement à la figure 1 au repère 18. Il est à noter que le film 18 n'a pas de rôle particulier de protection à jouer en dehors de son apacité à la lumière, et de ce fait n'est pas de nature très critique. Lui aussi peut être constitué d'une résine photopolymérisable chargée d'un pigment absorbant. Appliqué sous faible épaisseur, au tampon par exemple, la polymérisation complète de ce film peut être obtenue malgré un pouvoir absorbant de la lumière élevé.

A l'aide de la figure 2 on va décrire un procédé au cours duquel on prévoit une opération de pré-enrobage d'un dispositif selon un volume relativement faible, précédant une opération d'enrobage final créant la partie externe de l'encapsulation. La figure 2 montre l'extrémité de deux conducteurs métalliques 21 et 22 faisant partie d'un ensemble linéaire de conducteurs semblables non représentés, qui constituent une bande métallique découpée connue sous le nom de peigne. Un cristal semiconducteur 24 de diode électroluminescente est fixé au centre d'une cavité réfléchissante 25 portée par l'extrémité du conducteur métallique 21, au moyen d'une colle conductrice, selon une technique connue. Un fil conducteur 23 relie également une partie active du cristal au conducteur 22.

Une goutte de résine 26 est déposée dans la cavité réfléchissante 25 au moyen d'une aiguille 27.

Le volume de la goutte de résine 26 est choisi de sorte que la cavité 25 soit pratiquement remplie de résine et que le cristal semiconducteur 24 soit recouvert.

Selon l'invention, la résine utilisée pour le pré-enrobage est de même nature (c'est à dire de la même famille), et de préférence, la même que celle employée pour l'enrobage final.

La résine de pré-enrobage fournie par la goutte 26 déposée dans la cavité 25 est ensuite irradiée aux ultra-violets jusqu'à polymérisation complète, ce qui demande environ 1 minute, avant de procéder à l'enrobage final.

Les figures 3A et 3B illustrent une opération intermédiaire qui peut, selon l'invention, être avantageusement pratiquée avant l'enrobage final. Sur ces figures une paire seulement de conducteurs 31, 32 correspondant à une diode électroluminescente est représentée bien que ces conducteurs fassent partie d'un peigne métallique à positions multiples répétant plusieurs fois les mêmes éléments assemblés en bande longitudinale. On opère un trempage dans un bain de résine photopolymérisable 33 du dispositif actif 34 ainsi que d'une partie des conducteurs 31 et 32.

Après retrait du bain de résine 33, les parties précédemment immergées du composant se trouvent recouvertes d'un film 35 relativement mince de résine, comme indiqué à la figure 3B, film qui est ensuite irradié aux rayons ultra-violets jusqu'à polymérisation complète. Comme symbolisé par les flèches 36, ou utilise avanteusement pour cette opération une irradiation frappant le film 35 selon de multiples directions de manière à obtenir une polymérisation complète de celui-ci après une durée d'irradiation relativement brève.

Une particularité importante de cette opération réside dans le fait que la limite symbolisée sur la figure 3B par la ligne 37, entre la partie des conducteurs 31 et 32 recouverte du film de résine 35 et la partie de ces mêmes conducteurs qui n'est pas recouverte dudit film est choisie pour correspondre très sensiblement à la limite de l'enrobage final ultérieur.

Avantageusement le type de la résine photopolymérisable 33 utilisée en bain de trempage est identique à celui de la résine utilisée pour l'enrobage final.

En procédant ainsi, on observe qu'il n'existe aucune discontinuité décelable dans le matériau d'enrobage lorsque le composant est terminé, au niveau de l'interface entre le film 35 et la résine de l'enrobage final.

L'application d'un film relativement mince de résine sur les parties du composant qui seront ultérieurement enrobées peut être complémentaire de l'opération de pré-enrobage décrite à propos de la figure 2, et effectuée à la suite. Cependant elle peut encore, si on le désire, tenir lieu d'opération de pré-enrobage, à la condition d'éviter, par un traitement sous vide par exemple, d'emprisonner une bulle d'air dans la cavité réfléchissante 25 (figure 2), ce qui serait préjudiciable à la qualité optique notamment, du composant encapsulé. Bien qu'optionnelle, l'application d'un film mince de résine décrite à propos des figures 3A et 3B a révélé une exceptionnelle étanchéité des composants ainsi traités lors de tests de pénétration des solvants. En particulier, aucune pénétration le long des conducteurs métalliques n'a pu être observée. Cette indication expérimentale est interprétée comme résultant d'une excellente adhérence du film de résine sur les conducteurs, probablement favorisée par une légère contradiction de ce film lors du retrait de polymérisation.

A l'aide de la figure 4 est décrit un procédé d'enrobage final utilisant un moule en vue d'obtenir une partie externe de l'encapsulation qui soit de forme reproductible et contrôlée au moins en certaines portions spécifiques de son contour.

Comme pour les figures 2, 3A et 3B, l'exemple représenté à la figure 4 concerne l'encapsulation d'une diode électroluminescente comportant les conducteurs métalliques 41 et 42 reliés électriquement au cristal semiconducteur 43. Un moule 45 à paroi pratiquement transparente à la lumière ultra-violette comporte une cavité 46 dont la forme est à reproduire avec le composant final à enrober. La partie la plus critique du contour de l'encapsulation est celle du dôme optique 46a terminant le côté frontal du composant, dôme à partir duquel la lumière est émise par la diode selon une distribution angulaire déterminée en raison de la forme de ce dôme, forme qui doit être respectée fidèlement au moulage.

Le matériau constituant le moule 45 peut être un matériau polymère comme le polyéthylène haute densité, ou encore du verre.

Le moule 45 est garni d'une quantité déterminée de résine photopolymérisable 47 à l'état liquide, et le dispositif muni de ses conducteurs 41 et 42 est introduit dans le moule et fixé en position convenable par rapport au moule, par des moyens de fixation non représentés. On irradie alors aux rayons ultra-violets la résine 47 à travers le moule 45 selon une direction unique représentée par les flèches 50 de sorte que la polymérisation commence essentiellement à se produire le long du dôme optique 46a. La direction de l'irradiation aux ultra-violets est maintenue au cours de la polymérisation de telle sorte que le front de polymérisation 51, représenté en tirets sur la figure, se déplace au cours du temps, par une translation verticale qui découle de la direction privilégiée choisie pour l'irradiation. En procédant de cette manière, on observe que le contour externe de l'enrobage est fidèlement respecté et que les contraintes dues au retrait de polymérisation sont minimales.

Bien entendu, le procédé décrit en référence à la figure 4 qui montre un seul dispositif en cours d'enrobage s'applique aussi bien à une opération effectuée sur un ensemble de dispositifs identiques disposés sur un peigne, en prévoyant le nombre nécessaire de moules disposés linéairement sur un support.

On remarque à la figure 4 que le moule 45 n'est pas obturé à sa partie supérieure et que l'on a prévu une quantité initiale de résine 47 formant un ménisque 52. Ce ménisque forme un volume excédentaire de matière à l'état liquide qui polymérise en tout dernier lieu. Il est libre de fournir au cours du processus, une compensation au retrait de polymérisation de sorte qu'en fin d'opération le ménisque 52 se trouve remplacé par une surface sensiblement plane. La partie supérieure de l'encapsulation d'où émergent les conducteurs 41 et 42 est une partie dont la forme exacte ne présente pas d'éxigences géométriques particulières. De plus, elle se situe à l'opposé du dôme optique 46a ce qui convient bien avec le choix de la direction de l'irradiation aux ultra-violets indiquée par les flèches 50.

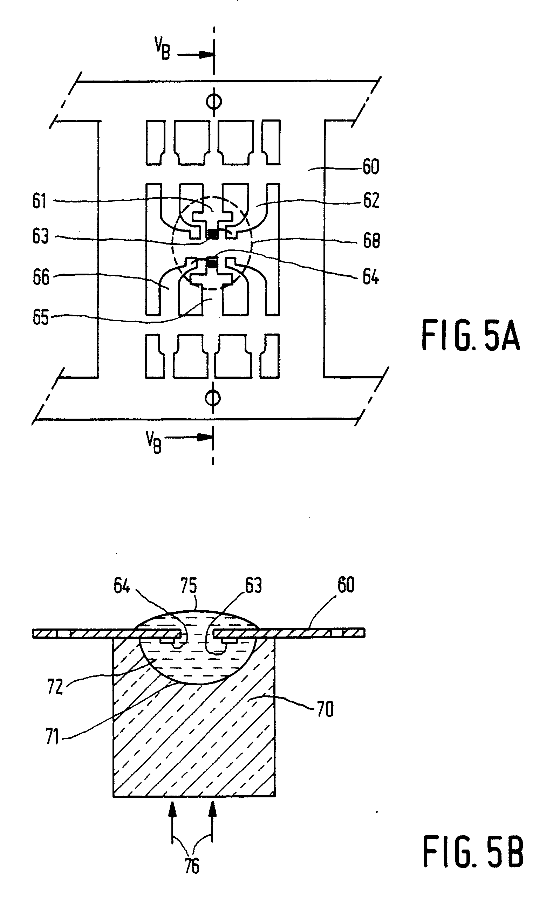

Les figures 5A et 5B sont relatives à la mise en oeuvre du procédé selon l'invention dans le cas d'un photocoupleur.

La figure 5A représente une position d'un peigne métallique 60 comportant six conducteurs dont les parties libres sont dirigées vers le centre du motif, par rangées de trois se faisant face. Au conducteur 61 est fixé le cristal 63 d'une diode électroluminescente dont la jonction est également reliée par fil au conducteur 62. Faisant face à ces éléments, le cristal semiconducteur 64 d'un photodétecteur est fixé sur un conducteur 65 et également relié par fil au conducteur 66.

Selon une technique connue, le couplage optique entre les deux éléments semiconducteurs actifs est obtenu en surmontant l'ensemble d'un dôme optique de forme appropriée sur la paroi duquel la lumière émise par le cristal 63 de diode électroluminescente est réfléchie en direction du cristal 64 du photodétecteur.

A la figure 5A le contour de base du dôme optique en question est figurée par le trait pointillé 68.

La figure 5B représente une section du peigne 60 selon l'axe VB au cours d'une opération de moulage du dôme optique au moyen d'une résine photopolymérisable du type déjà indiqué.

A cet effet un moule transparent 70 portant une cavité 71 de forme appropriée préalablement garni d'une certaine quantité de résine 72 à l'état liquide, est appliqué contre le peigne 60.

La position du peigne 60 est telle que les cristaux semiconducteurs 63 et 64 sont orientés vers la cavité 71 du moule 70.

La quantité de résine 72 mise en oeuvre est telle qu'un ménisque 75 est formé au-dessus des conducteurs du peigne 60. Une irradiation par lumière ultra-violette est alors appliquée dans la direction indiquée par les flèches 76 de sorte que la polymérisation commence au voisinnage de la partie frontale de la cavité 71 qui est la portion du moulage dont la forme doit être fidèlement respectée. la polymérisation progresse ensuite sensiblement par translation de son front dans le sens vertical ascendant.

Le ménisque 75 de résine encore liquide est libre de se déformer et la résine qui y est contenue vient compenser le retrait consécutif à la polymérisation. Lorsque les parties de résine exposées aux ultra-violets sont polymérisées, le moule 70 est retiré. Si nécessaire, une irradiation supplémentaire aux ultra-violets, en direction de la partie supérieure du peigne 60 peut être utilisée dans le but de parfaire la polymérisation des portions de résine qui ont été masquée du rayonnement ultra-violets lors de l'irradiation principale selon la direction 76.

Le dôme optique obtenu après démoulage est ensuite revêtu d'un film chargé avec un pigment blanc.

Cette opération peut être réalisée par toute technique connue mais également par un procédé analogue à celui décrit à la figure 5B, c'est-à-dire par moulage de résine photosensible chargée, à l'aide d'un moule analogue au moule 70, mais dont la cavité 71 présente un contour agrandi de l'épaisseur désirée pour le film.

Bien qu'un tel film soit peu transparent aux rayons ultra-violets, une polymérisation convenable est néanmoins obtenue en raison de sa faible épaisseur. Avantageusement, la résine du film rapporté sur le dôme optique est de même nature que celle utilisée pour le dôme, hormi bien entendu le fait qu'elle contient une charge d'un pigment tel que de la poudre d'oxyde de titane par exemple.

Il faut noter enfin que dans le cas où on cherche à obtenir une encapsulation de contour défini comme à la figure 5B, mais que le support du dispositif actif est du type de celui représenté à la figure 1 au repère 11 c'est à dire un support plan, on pratique alors au voisinage du dispositif actif au moins un perçage du support.

En opérant alors comme indiqué à propos de la figure 5B et en garnissant la cavité du moule d'une quantité de résine excédentaire par rapport au volume d'encapsulation finale, le volume de résine liquide qui pénètre dans le (ou les) perçage-(s) est libre de se déplacer au cours du processus de polymérisation, et compense progressivement la réduction de volume due au retrait de polymérisation. On choisit donc un diamètre de perçage approprié de telle sorte que le volume excédentaire de résine liquide qu'il peut contenir au stade initial de l'opération, soit suffisant.

## Revendications

1. Procédé d'encapsulation d'un composant électronique consistant à ce que, après avoir fixé et relié électriquement un dispositif actif à des conducteurs métalliques, on effectue, au moyen d'une résine synthétique, au moins un enrobage au dehors duquel les conducteurs émergent partiellement, caractérisé en ce qu'en tant que résine synthétique de base on utilise une résine de la famille des éthoxy bisphénol A diméthacrylates dans laquelle on a ajouté un composé photoinitiateur produisant des radicaux par photo-scission ou par abstraction intermoléculaire d'hydrogène, à une concentration comprise entre 0,2 et 3 % en poids et en ce qu'on irradie ensuite ladite résine avec des rayons ultra-violets pour obtenir la polymérisation de l'enrobage.

2. Procédé selon la revendication 1 dans lequel le processus d'encapsulation comporte une opération de pré-enrobage appliquée directement au dispositif actif et une opération d'enrobage final créant la partie externe de l'encapsulation au sein de laquelle le volume de pré-enrobage se trouve inclus, caractérisé en ce qu'on untilise pour l'opération de pré-enrobage une résine de base de même nature que celle employée pour l'enrobage final, que l'on irradie par rayons ultra-violets avant de procéder à l'opération d'enrobage final.

3. Procédé selon l'une des revendications 1 ou 2 dans lequel on utilise un moule en vue d'obtenir une partie externe de l'encapsulation qui soit de forme contrôlée et reproductible au moins en certaines portions spécifiques de son contour caractérisée en ce qu'on utilise un moule à paroi pratiquement transparente à la lumière ultra-violette, en ce qu'après avoir fixé en positions respectives et convenables le dispositif muni de ses conducteurs et le moule garni d'une quantité convenable de résine, on irradie aux ultra-violets la résine à travers le moule selon une direction privilégiée choisie pour initier la polymérisation sur la portion de contour externe de l'encapsulation dont la forme doit être la plus fidèlement respectée, conditions qui sont maintenues de sorte qu'un front de polymérisation progressive se déplace au sein de la résine, par translation dans le sens de ladite direction privilégiée.

4. Procédé selon la revendication 3 caractérisé en ce qu'en dehors de ladite portion de contour externe de l'encapsulation dont la forme doit être respectée et sensiblement à son opposé, on prévoit un volume excédentaire de résine par rapport au volume représenté par l'encapsulation à l'état polymérisé, et en ce que ce volume excédentaire est maintenu libre de se déplacer au cours du processus de polymérisation de manière à compenser du fait du retrait de polymérisation, la réduction progressive de volume total de résine.

5. Procédé selon l'une quelconque des revendications 1 à 4 caractérisé en ce qu'avant l'opération finale d'enrobage on applique un film relativement mince de résine photopolymérisable de même nature sur le dispositif et les parties des conducteurs qui seront aussi ultérieurement recouvertes par l'enrobage final, et en ce qu'on irradie ledit film aux rayons ultra-violets jusqu'à polymérisation complète de celui-ci avant de procéder à l'enrobage final.

6. Procédé selon l'une quelconque des revendications 1 à 5 appliqué à l'enrobage de dispositifs semiconducteurs optoélectroniques.

## Claims

1. A method of encapsulating an electronic component consisting in that, after having fixed and electrically connected an active device to metallic conductors, at least one coating step is carried out by means of a synthetic resin, the conductors emerging in part from this coating, characterized in that as basic synthetic resin a resin is used of the family of ethoxy bisphenol A dimethacrylates, to which is added a photo-initiator constituent which produces radicals by photo-scission or by intermolecular abstraction of hydrogen at a concentration lying between 0.2 and 3 % by weight, and in that the said resin is then irradiated with ultraviolet rays to obtain the polymerization of the coating.

2. A method as claimed in Claim 1, in which the encapsulation process comprises a step of precoating applied directly to the active device and a final coating step producing the external part of the encapsulation in which the volume of precoating is included, characterized in that for the precoating step a basic resin is used of the same nature as that used for the final coating, which is irradiated with ultraviolet rays before the final coating step is carried out.

3. A method as claimed in any one of Claims 1 or 2, in which a mould is used to obtain an external part of the encapsulation which has a controlled and reproducible shape at least at certain specific portions of its contour, characterized in that a mould is used having walls practically transparent to ultraviolet light, and in that, after having fixed in suitable respective positions the device provided with its conductors and the mould provided with a suitable quantity of resin, the resin is irradiated with ultraviolet radiation through the mould in a preferential direction chosen to initiate the polymerization on the external contour portion of the encapsulation whose shape should be reproduced with the highest possible fidelity, which conditions are maintained so that a front of progressive polymerization is displaced within the resin by propagation in the said preferential direction.

4. A method as claimed in Claim 3, characterized in that apart from the said external portion of the contour of the encapsulation, whose shape should be reproduced, and substantially opposite thereto an excess volume of resin is provided with respect to the volume represented by the encapsulation in the polymerized state, and in that this excess volume is maintained so as to be free to be displaced during the polymerization process so as to compensate for the progressive reduction of the overall volume of the resin resulting from the polymerization shrinkage.

5. A method as claimed in any one of Claims 1 to 4, characterized in that before the final coating step a comparatively thin film of photopolymerizable resin of the same nature is applied to the device and to the parts of the conductors which will also be subsequently covered by the final coating, and in that the said film is irradiated with ultraviolet radiation until it is completely polymerized before the final coating is carried out.

6. A method as claimed in any one of Claims 1 to 5 applied to the coating of optoelectronic semiconductor devices.

**Ansprüche**

1. Verfahren zum Einkapseln eines elektronischen Bauteils, daraus bestehend, daß, nachdem eine aktive Anordnung befestigt und mit metallischen Leitern elektrisch verbunden ist, wenigstens ein Bedeckungsschritt mit einem Kunstharz durchgeführt wird, wobei die Leiter aus dieser Bedeckung teilweise herausragen, **dadurch gekennzeichnet,** daß als Ausgangskunstharz ein Harz verwendet wird aus der Familie von Ethoxybisphenol-A-Dimethakrylaten, wobei diesem Stoff ein Photoinitiatoranteil hinzugefügt wird, der durch Lichtspaltung oder durch intermolekulare Entziehung von Wasserstoff mit einer Konzentration zwischen 0,2 und 3 Gew.% Radikale erzeugt, und daß das genannte Harz danach zum Polimerisieren der Bedeckung mit UV-Strahlen bestrahlt wird.

2. Verfahren nach Anspruch 1, wobei das Einkapseln einen Verfahrensschritt aufweist, bei dem unmittelbar auf der aktiven Anordnung eine Vorbedeckung angebracht wird, und wobei ein Endbedeckungsschritt den Außenteil der Einkapselung schafft, in dem sich die Vorbedeckung befindet, **dadurch gekennzeichnet,** daß für den Vorbedeckungsschritt ein Ausgangsharz derselben Art verwendet wird wie für die Endbedeckung, wobei diese Vorbedeckung vor der Durchführung des Endbedeckungsschrittes mit UV-Strahlen bestrahlt wird.

3. Verfahren nach einem der vorstehenden Ansprüche 1 oder 2, wobei zum Erhalten des Außenteils der Einkapselung ein Formteil verwendet wird, von dem wenigstens bestimmte spezifische Teile des Umrißes geprüft und reproduzierbar sind, **dadurch gekennzeichnet,** daß ein Formteil verwendet wird mit für UV-Licht nahezu durchläßigen Wänden, und daß nachdem die Anordnung mit ihren Anschlüßen an den betreffenden geeigneten Stellen befestigt worden ist, der Formteil mit einer geeigneten Harzmenge versehen wird, wonach das Harz durch den Formteil hindurch aus einem solchen bevorzugten Abstand mit UV-Strahlung bestrahlt wird, daß die Polymerisation des äußeren Umrißteils der Einkapselung eingesetzt wird, deren Form mit höchst möglicher Treue reproduziert werden soll, wobei die Umstände derart beibehalten werden, daß eine Front fortschreitender Polymerisation durch Ausbreitung in der genannten bevorzugten Richtung durch das Harz verschoben wird.

4. Verfahren nach Anspruch 3, **dadurch gekennzeichnet,** daß außerhalb des genannten äußeren Teils des Umrißes der Einkapselung, deren Form reproduziert werden sollte, und im wesentlichen gegenüber derselben eine gegenüber der Menge der Einkapselung im polymerisierten Zustand zusätzliche Harzmenge angebracht wird, und daß diese zusätzliche Menge verfügbar gehalten wird um während des Polymerisationsprozeßes die progressive Gesamtmengenverringerung als Ergebnis der Polymerisationsschrumpfung des Harzes auszugleichen.

5. Verfahren nach einem der vorstehenden Ansprüche 1 bis 4, **dadurch gekennzeichnet,** daß vor dem Endbedeckungsschritt ein relativ dünner Film eines durch Licht polymerisierbaren Harzes derselben Art auf der Anordnung sowie auf denjenigen Teilen der Anschlüße angebracht wird, die nachher ebenfalls durch die Endbedeckung bedeckt werden, und daß dieser Film vor dem Anbringen der Endbedeckung mit UV-Strahlung bestrahlt wird, bis er völlig polymerisiert ist.

6. Verfahren nach einem der vorstehenden Ansprüche 1 bis 5, angewand bei der Bedeckung optoelektronischer Halbleiteranordnungen.

FIG.1

FIG. 2

FIG. 3 a

FIG. 3 b

FIG. 4

FIG. 5A

FIG. 5B